# EUROPEAN PATENT APPLICATION

(11) **EP 2 768 028 A1**
(43) Date of publication of application: **20.08.2014**
(21) Application number: 12840555.2
(22) Date of filing: 24.08.2012
(51) Int. Cl.: H01L 31/04, B26D 1/08, B26D 3/06

(54) **SOLAR CELL MANUFACTURING METHOD AND SOLAR CELL MODULE**

(30) Priority: 14.10.2011 JP 2011226514
(71) Applicant: Nitto Denko Corporation, Ibaraki-shi, Osaka 567-8680 (JP)
(72) Inventor: WATANABE Taichi, Ibaraki-shi Osaka 567-8680 (JP); TERAJI Seiki, Ibaraki-shi Osaka 567-8680 (JP); KAWAMURA Kazunori, Ibaraki-shi Osaka 567-8680 (JP); NISHII Hiroto, Ibaraki-shi Osaka 567-8680 (JP); MORITA Shigenori, Ibaraki-shi Osaka 567-8680 (JP)
(74) Representative: Grünecker, Kinkeldey, Stockmair & Schwanhäusser
(86) International application number: PCT/JP2012/071406
(87) International publication number: WO 2013/054600

(57) **Abstract**

A production method capable of efficiently producing a solar battery cell which hardly causes an electric short circuit at the cut end surface of a solar battery element is provided. A method for producing a solar battery cell of the present invention in which a solar battery cell is obtained from an elongated solar battery element 11 including an elongated flexible base material 41, a first electrode layer 211, a light absorbing layer 31, and a second electrode layer 221 in this order, and the method includes a partial removal step of forming one or more partial removal portion 61 each extending like a belt at a plurality of parts in the surface of the solar battery element 11 by partially removing layers of the second electrode layer 221 through to the light absorbing layer 31 or the second electrode layer 221 through to the first electrode layer 211, and a cutting step of cutting the solar battery element 11 at the partial removal portion 61.

## Description

### TECHNICAL FIELD

The present invention relates to a method for producing individual solar battery cells by cutting an elongated solar battery element, and so on.

### BACKGROUND ART

A solar battery module is constituted by electrically connecting a plurality of solar battery cells.

The plurality of solar battery cells can be obtained by, for example, cutting an elongated solar battery element including a base material, a first electrode layer, a light absorbing layer, and a second electrode layer in this order.

Conventionally, when a solar battery element is cut, generally the whole solar battery element is cut along a thickness direction using a tool such as a glass cutter or an ultrasonic cutter, or a cutting machine equipped with a push-cut blade. However, when the solar battery element is cut, a first electrode layer and a second electrode layer or the second electrode layer and a conductive base material are come into contact with each other at the cut surface, so that the element is short-circuited. When the element is short-circuited, a current loss is increased, leading to deterioration of device characteristics and reliability of a solar battery.

For example, Patent Document 1 discloses that by applying a force from the back surface of an insulating base material using a tool such as a glass cutter or an ultrasonic cutter, cutting processing of the base material is performed. In this cutting method, a force is applied such that layers of a solar battery element, which are stacked on the base material, are pushed apart on both sides, whereby the base material is cut without causing electrodes to come into contact with each other, so that short circuit of electrodes is prevented. According to this method, however, when the element has a metal base material having conductivity, it is difficult to prevent short circuit between the metal base material and electrodes because flash (burrs generated at the cut end surface) occurs at the cut surface at the time of cutting.

Patent Document 2 discloses that for preventing short circuit of electrodes of a solar battery element, an insulating thin film is formed at the cut surface by introducing a plurality of kinds of gases during cutting processing with a laser beam. According to this method, however, when the base material is metal, it is difficult to perform processing with high accuracy because the reflection coefficient of the laser beam is high.

Patent Document 3 discloses that for preventing short circuit of electrodes of a solar battery element, the cut surface of the solar battery element is irradiated with microplasma, whereby the cut surface is etched to form thin lines. According to this method, however, a light absorbing layer should also be irradiated with microplasma, and therefore damage may be caused to the light absorbing layer.

Patent document 1: JP-A-8-116078
Patent document 2: JP-A-8-139351
Patent document 3: JP-4109585

### DESCRIPTION OF EMBODIMENTS

An object of the present invention is to provide a production method capable of efficiently producing a solar battery cell which hardly causes an electric short circuit at the cut end surface, and a solar battery module using the cell.

In a method for producing a solar battery cell according to the present invention, a solar battery cell is obtained from an elongated solar battery element including an elongated flexible base material, a first electrode layer, a light absorbing layer, and a second electrode layer in this order, wherein the method includes: a partial removal step of forming on the solar battery element at least one partial removal portion extending like a belt by partially removing layers of the second electrode layer through to the light absorbing layer or the second electrode layer through to the first electrode layer; and a cutting step of cutting the solar battery element at the partial removal portion.

Preferably, in the partial removal step, the width of the partial removal portion is formed equal to or larger than the width of a cutting tool.

In another method for producing a solar battery cell according to the present invention, a solar battery cell is obtained from an elongated solar battery element including an elongated flexible base material, a first electrode layer, a light absorbing layer, and a second electrode layer in this order, wherein the method includes: a partial removal step of forming on the solar battery element at least two partial removal portions extending like a belt by partially removing layers of the second electrode layer through to the light absorbing layer or the second electrode layer through to the first electrode layer; and a cutting step of cutting the solar battery element between the two partial removal portions.

In a preferable method for producing a solar battery cell according to the present invention, removal in the partial removal step is performed by machining processing by a knife edge-shaped cutlery or a rotary blade, or irradiation of laser beams, and cutting in the cutting step is performed by pressing with a push-cut blade.

In a preferable method for producing a solar battery cell according to the present invention, in the partial removal step, the belt-like partial removal portion is formed in a direction substantially orthogonal to a longer direction of the elongated solar battery element.

In another aspect of the present invention, a solar battery module is provided.

This solar battery module includes a plurality of solar battery cells obtained by any one of the above methods, and the plurality of solar battery cells are electrically connected to one another.

According to the production method of the present invention, short circuit can be prevented at the cut end surface of a solar battery element. Further, according to the present invention, individual solar battery cells can be obtained efficiently from an elongated solar battery element.

### BRIEF DESCRIPTION OF THE DRAWINGS

Fig. 1 illustrates a sectional view of a solar battery cell according to one embodiment of the present invention.
Fig. 2 illustrates a sectional view of an elongated solar battery element according to one embodiment (where both sides of the element are not shown).
Fig. 3 illustrates a reference view showing the concept of a partial removal step and a cutting step.
Fig. 4 illustrates a plan view of a solar battery element according to one embodiment in which one partial removal portion is formed at a cut portion by performing a partial removal step.
Fig. 5 illustrates a sectional view taken along the line V-V' in Fig. 4.
Fig. 6 illustrates a plan view of a solar battery element according to another embodiment in which one partial removal portion is formed at a cut portion by performing a partial removal step.
Fig. 7 illustrates a sectional view of a solar battery element according to one embodiment in which two partial removal portions are formed at a cut portion by performing a partial removal step.
Fig. 8 illustrates a sectional view taken along the line VIII-VIII' in Fig. 7.
Fig. 9 illustrates a schematic side view of a solar battery module according to one embodiment (where a portion filled with a sealing resin is gray-painted).

The present invention will be described below with reference to the drawings. It is to be noted that dimensions such as layer thickness and length in the drawings are different from the actual dimensions.

In this specification, the phrase "AAA to BBB" means "AAA or more and BBB or less".

### [Structure of solar battery cell]

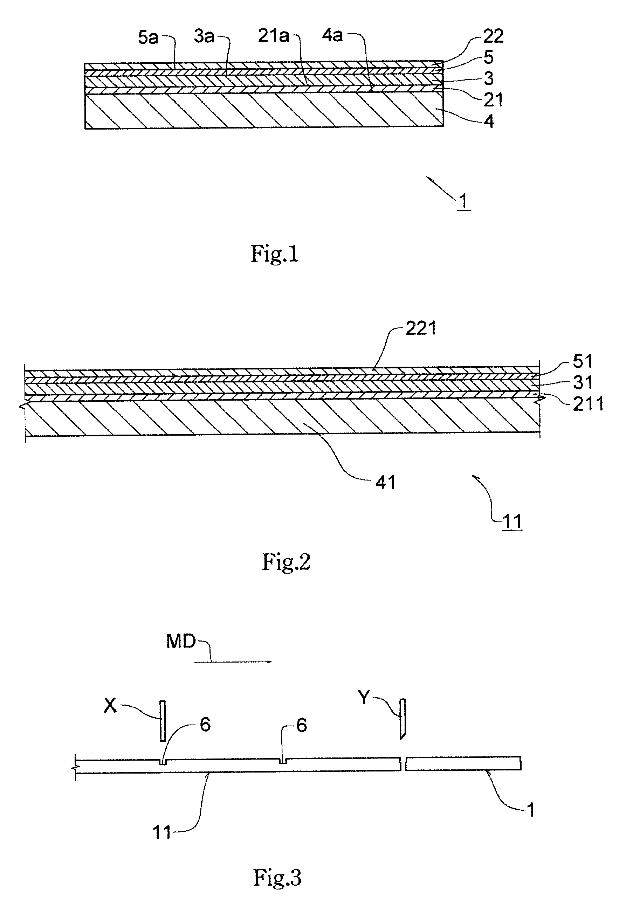

Fig. 1 illustrates a schematic sectional view showing an example of a configuration of a solar battery cell that is obtained by a production method of the present invention.

A thin film solar battery cell 1 prepared by the production method of the present invention has a first electrode layer 21, a light absorbing layer 3 provided on one surface 21a of the first electrode layer 21, and a second electrode layer 22 provided on one surface 3a of the light absorbing layer 3. The first electrode layer 21 is provided on one surface 4a of a base material 4. A buffer layer 5 may be provided between the light absorbing layer 3 and the second electrode layer 22 as necessary. A barrier layer (not illustrated) for suppressing diffusion of impurities derived from the base material may be provided in at least one of spaces between the first electrode layer 21 and the light absorbing layer 3 and between the first electrode layer 21 and the base material 4, or an antireflection film (not illustrated) may be provided on the second electrode layer 22 as necessary.

The surfaces 21a, 3a and 4a of the layers indicate upward-facing surfaces of the layers in Fig. 1, but they may be downward-facing surfaces (this depends merely on a direction in which the drawing is shown).

The solar battery cell 1 prepared in the production method of the present invention is not limited to the illustrated structure as long as it has the light absorbing layer 3 between the first electrode layer 21 and the second electrode layer 22. For example, the solar battery cell 1 prepared in the production method of the present invention may be one that does not have the buffer layer 5. Alternatively, the solar battery 1 may have any other layer provided in one or more selected from spaces between the layers 4 and 21 and 3 and 5 and 22.

The base material 4 is not particularly limited, and examples thereof include metal-based base materials and resin-based base materials.

Examples of the metal-based base material include a stainless steel base material and an aluminum base material. Preferably the metal-based base material has conductivity. Examples of the resin-based material include a resin sheet excellent in heat resistance, such as a polyimide sheet, and a resin sheet which is excellent in heat resistance and which has conductivity are preferred. When impurities are thermally diffused from the base material to adversely affect the solar battery cell, the barrier layer described above may be formed.

A thickness of the base material 4 is not particularly limited, but the thickness is 10 µm to 100 µm when a metal-based base material is used, and the thickness is 20 µm to 500 µm when a resin-based base material is used.

The first electrode layer 21 is formed on one surface 4a of the base material 4. The material for forming the first electrode layer 21 is not particularly limited, but for example, a high-melting-point metal having high corrosion resistance, such as molybdenum, titanium or chromium, is preferred.

A thickness of the first electrode layer 21 is not particularly limited, but is normally 0.01 µm to 1.0 µm.

When a barrier layer is formed between the base material 4 and the first electrode layer 21, or the like for suppressing impurities derived from the base material to thermally diffuse, the material for forming the barrier layer is not particularly limited, and for example, SiO₂, Al₂O₃, TiO₂, Cr or the like may be used. A thickness of the barrier layer is not particularly limited, but is normally 0.05 µm to 5.0 µm.

The material for forming the light absorbing layer 3 is not particularly limited, and examples thereof include a silicon-based material such as amorphous silicon, a compound-based material such as CdTe, and a chalcopyrite-based material.

A compound-based light absorbing layer is preferred, and a chalcopyrite-based light absorbing layer is more preferred because they have high photoelectric conversion efficiency and reduced time-related degradation.

For example, the light absorbing layer 3 formed on one surface 21a side of the first electrode layer 21 is a chalcopyrite-based p-type light absorbing layer.

The chalcopyrite-based compound is a generic name of compounds which include Ib group metals, IIIb group metals and VIb group elements of the periodic table of elements and form a chalcopyrite-type structure. Examples of the chalcopyrite compound include CuInSe₂, CuGaSe₂, CuAlSe₂, Cu(In,Ga)Se₂, Cu(In,Ga)(S,Se)₂, Cu(In,Al)Se₂, Cu(In,Al)(S,Se)₂, CuInS₂, CuGaS₂, CuAlS₂, AgInS₂, CuGaSe₂, AgInSe₂, AgGaSe₂, CuInTe₂, CuGaTe₂, AgInTe₂ and AgGaTe₂. Preferably the light absorbing layer of the present invention contains at least Cu, In and Se as a chalcopyrite compound.

A thickness of the light absorbing layer 3 is not particularly limited, but is normally 0.5 µm to 3 µm.

The buffer layer 5 is formed on one surface 3a of the light absorbing layer 3. The material for forming the buffer layer 5 is not particularly limited, and examples thereof include CdS, ZnMgO, ZnO, ZnS, Zn(OH)₂, In₂O₃, In₂S₃, and Zn(O, S, OH) that is a mixed crystal of these compounds. The buffer layer 5 may include only one layer, or include two or more layers.

A thickness of the buffer layer 5 is not particularly limited, but is normally 10 nm to 400 nm.

The second electrode layer 22 is formed on one surface 5a of the buffer layer 5. When the buffer layer 5 is not formed, the second electrode layer 22 is formed on one surface 3a of the light absorbing layer 3. The material for forming the second electrode layer 22 is not particularly limited, and examples thereof include a zinc oxide-based material such as ZnO, and ITO. When a zinc oxide-based material is used as the forming material, the second electrode layer 22 having a low-value resistance can be formed by adding thereto a IIIb group elements (Al, Ga, B etc.) as a dopant.

A thickness of the second electrode layer 22 is not particularly limited, but is normally 0.05 µm to 2.5 µm

### [Method for producing solar battery cell]

In the present invention, an elongated solar battery element is formed, placed on a cutting schedule line, and sequentially cut to produce individual solar battery cells.

In the present invention "elongated" means a belt shape in which a length in one direction (longer direction) is sufficiently large as compared to a length in a direction orthogonal to the one direction, and the ratio of the length in the one direction to the length in the direction orthogonal to the one direction is 5 or more, preferably 10 or more.

### (Step of forming solar battery element)

In the present invention, an elongated base material having flexibility is used because solar battery cells can be produced continuously and at a high speed in a roll-to-roll method. The base material having flexibility is also called a flexible base material, and is a base material which can be wound around a roll. The metal-based base material and the resin-based base material generally have flexibility depending on their thicknesses.

The length of the base material in the longer direction and the length of the base material in the direction orthogonal to the longer direction are nor particularly limited, and may be appropriately designed. Hereinafter, the direction orthogonal to the longer direction is referred to as a "shorter direction" in some cases.

For example, when a base material having a length in the shorter direction, which is equal to the width of a solar battery cell to be produced, is used, individual solar battery cells can be obtained by cutting an elongated solar battery element only along the shorter direction.

As the above-mentioned base material, a base material (e.g. base material made of stainless steel, etc.) having a longer-direction length of 10 m to 1000 m, a shorter-direction length of 10 mm to 100 mm and a thickness of 10 µm to 50 µm is used.

The solar battery element is obtained by sequentially forming at least three layers: a first electrode layer, a light absorbing layer, and a second electrode layer on the elongated flexible base material.

The elongated base material wound around a roll is drawn out, and the first electrode layer is formed on one surface of the base material. The material for forming the first electrode layer is as described above.

The first electrode layer can be formed using a previously known method. Examples of the method for forming the first electrode layer include a sputtering method, a vapor deposition method, and a printing method.

A light absorbing layer such as the above-described chalcopyrite-based light absorbing layer is formed on one surface of the first electrode layer of the base material. The light absorbing layer can be formed using a previously known method. Examples of the method for forming the light absorbing layer include a vacuum deposition method, a selenization/sulfurization method, and a sputtering method.

Particularly, the chalcopyrite-based light absorbing layer has low adhesiveness to the first electrode layer formed of molybdenum or the like, but according to the production method of the present invention, the solar battery element can be cut while peeling between the light absorbing layer and the second electrode layer is prevented.

After the light absorbing layer is formed, a buffer layer may be formed on one surface thereof as necessary. The buffer layer can be formed using a previously known method. Examples of the method for forming the buffer layer include a solution growth technique (CBD method), a sputtering method and, a metal organic chemical vapor deposition method (MOCVD method).

For example, the buffer layer can be formed in the following manner: a base material having the light absorbing layer is immersed in a solution containing a precursor substance of a material for forming the buffer layer, and the solution is heated to cause a chemical reaction to proceed between the solution and one surface of the light absorbing layer (CBD method).

The second electrode layer is formed on one surface of the light absorbing layer of the base material (or formed on one surface of the buffer layer when the buffer layer is formed). The material for forming the second electrode layer is as described above.

The second electrode layer can be formed using a previously known method. Examples of the method for forming the second electrode layer include a sputtering method, a vapor deposition method, and a metal organic chemical vapor deposition method (MOCVD method).

When a solar battery cell having the barrier layer is to be obtained, the barrier layer is formed between the base material and the first electrode layer as necessary. The barrier layer can be formed using a previously known method. Examples of the method for forming the barrier layer include a sputtering method, a vapor deposition method, a CVD method, a sol-gel method, and a liquid phase deposition method.

In this way, an elongated solar battery element 11 as shown in Fig. 2 is obtained in which an elongated flexible base material 41, a first electrode layer 211, a light absorbing layer 31, a buffer layer 51, and a second electrode layer 221 are stacked in this order.

### (Partial removal step of solar battery element)

The partial removal step is a step of partially removing layers of the second electrode layer through to the light absorbing layer or the second electrode layer through to the first electrode layer in the solar battery element.

By carrying out this step, a partial removal portion extending like a belt in the shorter direction of the solar battery element is formed.

In the present invention, layers of the second electrode layer through to the light absorbing layer or the second electrode layer through to the first electrode layer are partially removed along a cutting schedule line or the vicinity thereof to form a partial removal portion, followed by cutting the solar battery element along a thickness direction at a partial removal portion forming region, whereby individual solar battery cells can be obtained.

Fig. 3 illustrates a conceptual view showing a series of steps of forming a partial removal portion on a solar battery element and cutting the solar battery element, and cutting out a solar battery cell from the element.

In Fig. 3, the solar battery element 11 drawn out from a roll is carried in a longer direction MD. A partial removal portion 6 is formed by partially removing layers of the second electrode layer through to the light absorbing layer or the second electrode layer through to the first electrode layer using a machining tool X in the course of the carrying.

Next, the solar battery element 11 is cut at a partial removal portion forming region using a cutting tool Y, thereby obtaining a solar battery cell 1.

By sequentially repeating this process, a plurality of solar battery cells 1 can be continuously and efficiently obtained from one solar battery element 11.

In the partial removal step, one partial removal portion may be formed including the cutting schedule line, or at least two (a plurality of) partial removal portions may be formed in the vicinity of the cutting schedule line. The cutting schedule line is a designed position which is designed to cut out individual solar battery cells from the solar battery element.

In description of this step, a case where one partial removal portion is formed for one cut portion and a case where a plurality of partial removal portions are formed for one cut portion are described separately.

### <Case where one partial removal portion is formed>

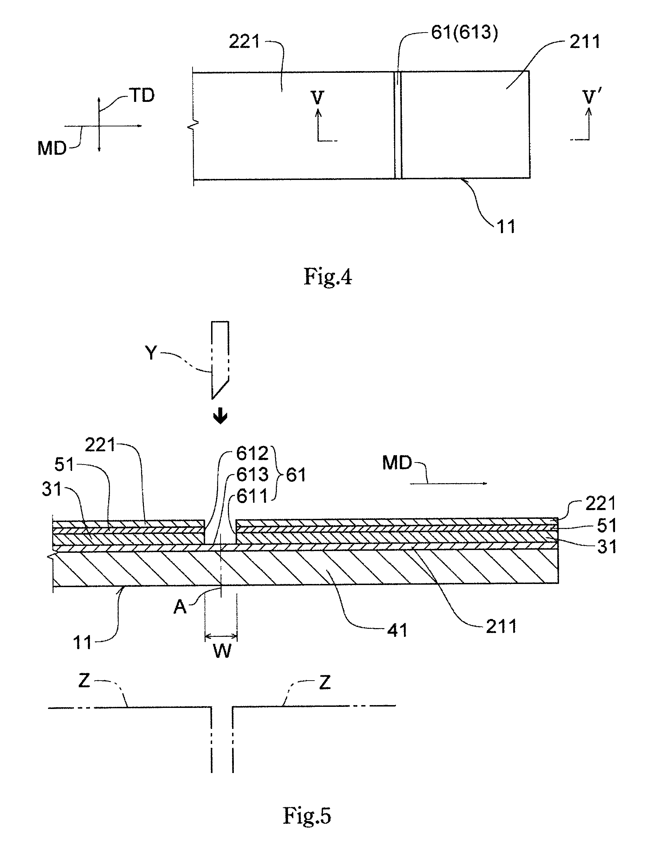

Fig. 4 illustrates a plan view of the solar battery element after a partial removal step is carried out. Fig. 5 illustrates a sectional view taken along the line V-V' in Fig. 4, and illustrates a sectional view when layers of the second electrode layer through to the first electrode layer are partially removed. In this specification, the solar battery element is described simply as an "element" in some cases.

In the partial removal step, at least one partial removal portion 61 is formed at a part in the surface of the elongated solar battery element 11 by partially removing layers of the second electrode layer 221 through to the light absorbing layer 31 (Figs. 4 and 5).

The partial removal portion 61 extends like a belt when viewing the element 11 in a plane as in Fig. 4, and is concave-shaped when viewing the element 11 in a cross section as in Fig. 5. That is, the partial removal portion 61 is a portion in which a concave formed in the element 11 extends like a belt and linearly in a shorter direction of the element 11.

The partial removal portion 61 is formed from a first end surface 611 and a second end surface 612, which are an aggregate of the end surfaces of layers of the second electrode layer 221 through to the light absorbing layer 31, and an electrode exposure surface 613 which is sandwiched between the first end surface 611 and the second end surface 612 and at which one surface of the first electrode layer 211 is exposed.

The partial removal portion 61 is formed so as to include a cutting schedule line A.

In this embodiment, for example, the partial removal portion 61 is formed so as to extend in a shorter direction TD of the elongated solar battery element 11. The partial removal portion 61 may be formed substantially in parallel with the shorter direction TD, or may be formed obliquely to the shorter direction in conformity to the shape of an ultimate solar battery module.

When the solar battery element 11 having a length in the shorter direction, which is equal to the width of a solar battery cell to be produced, is used, the partial removal portion may be formed only along the shorter direction. When a solar battery element having a length in the shorter direction, which allow two or more rows of solar battery cells to be cut out in the shorter direction, is used, the partial removal portion is also formed along the longer direction for cutting the element between rows (the same applies hereinafter).

The width W of the partial removal portion 61 is not particularly limited. However, when the width W is excessively small, the first end surface 611 or second end surface 612 may be caused to sag in a processing direction as a cutting tool scrapes the first end surface 611 or second end surface 612 when the cutting tool is applied to the partial removal portion 61 in a later-described cutting step. From such a point of view, the width W of the partial removal portion 61 is preferably equal to or larger than the width of the cutting tool. For example, when a laser beam is used as a machining tool, a laser beam having a small line width of 30 µm is available. Of course, a laser beam having a smaller line width can be used by utilizing a condensing lens or by making a vertical movement in a Z axis direction. Thus, when a laser beam is used, the width W of the partial removal portion 61 is preferably 30 µm or more, more preferably more than 40 µm, and especially preferably 50 µm or more.

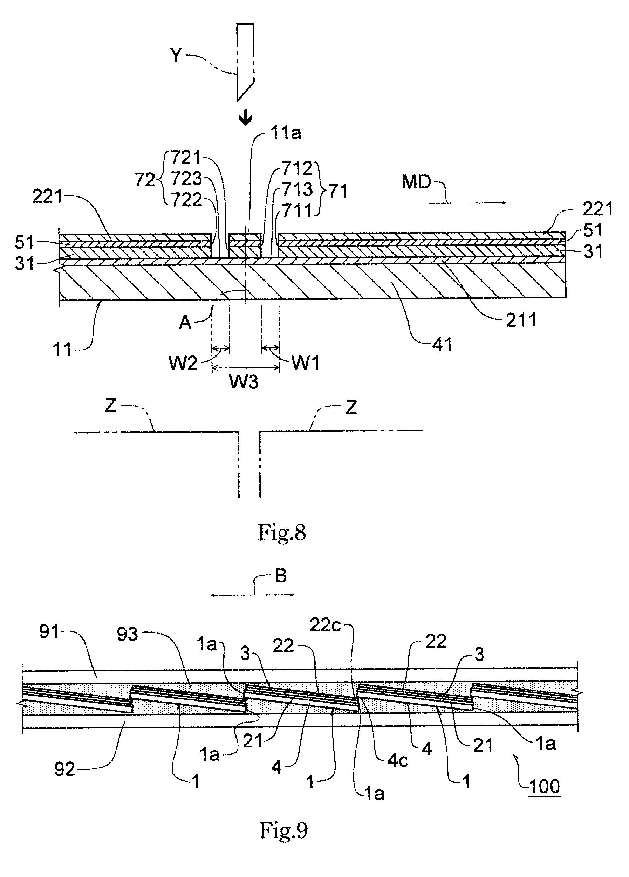

On the other hand, when the width W is excessively large, the yield of the solar battery cell is reduced, and a relatively long base material edge may protrude outward after cutting. When solar battery cells having a base material edge protruding lengthwise are arranged so as to overlap one another as in Fig. 9, the edge of the base material of one solar battery cell may be contacted by the lower surface of the base material of the adjacent solar battery cell to cause short circuit. From such a point of view, the width W of the partial removal portion 61 is preferably 20 mm or less, and more preferably 10 mm or less.

Examples of the method for partially removing layers of the second electrode layer 221 through to the light absorbing layer 31 (method for forming the partial removal portion) include mechanical machining such as machining by a knife edge-shaped cutlery and machining by a rotary blade, or machining by irradiation of laser beams. By using these machining tools, the above-described partial removal portion can be formed.

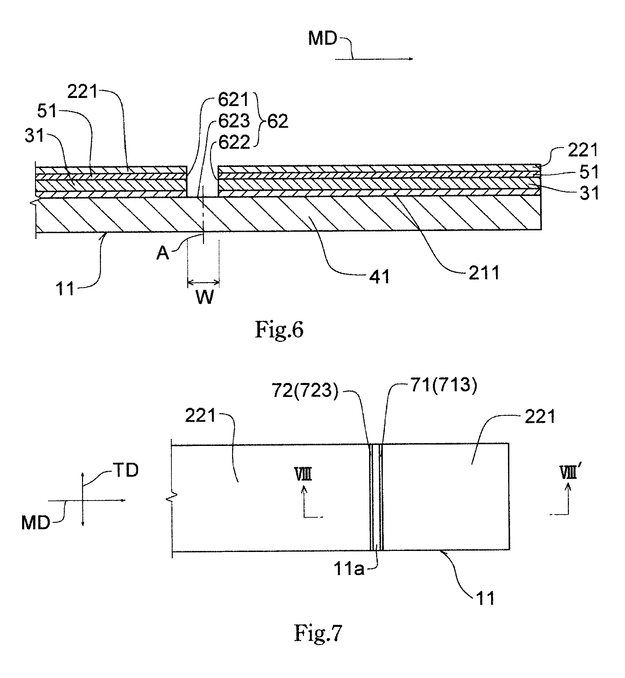

When layers of the second electrode layer 221 through to the first electrode layer 211 are partially removed, a partial removal portion 62 is formed, as shown in Fig. 6, from a first end surface 621 and a second end surface 622, which are an aggregate of the end surfaces of layers of the second electrode layer 221 through to the first electrode layer 211, and a base material exposure surface 623 which is sandwiched between the first end surface 621 and the second end surface 622 and at which one surface of the base material 41 is exposed.

The process for partially removing layers of the second electrode layer 221 through to the first electrode layer 211 is the same as the process for partially removing layers from the second electrode layer 221 through to the light absorbing layer 31 as described above except that the first electrode layer 211 is also removed. Therefore, detailed descriptions thereof are omitted, and similar symbols are used for denotation in Fig. 6.

### <Case where a plurality of partial removal portions are formed>

Fig. 7 illustrates a plan view of the solar battery element after a partial removal step is carried out. Fig. 8 illustrates a sectional view taken along the line VIII-VIII' in Fig. 7, and illustrates a sectional view when layers of the second electrode layer through to the base material are partially removed.

At least two partial removal portions 71 and 72 are formed at a part in the surface of the elongated solar battery element 11 by partially removing layers of the second electrode layer 221 through to the light absorbing layer 31 (Figs. 7 and 8).

Two partial removal portions 71 and 72 each extend like a belt when viewing the element 11 in a plane as in Fig. 7, and are each concave-shaped when viewing the element 11 in a cross section as in Fig. 8. That is, two partial removal portions 71 and 72 are each a portion in which a concave formed at a part in the surface of the element 11 extends like a belt and linearly in a predetermined direction of the element 11.

The first partial removal portion 71 is formed from a first end surface 711 and a second end surface 712, which are an aggregate of the end surfaces of layers of the second electrode layer 221 through to the light absorbing layer 31, and an electrode exposure surface 713 which is sandwiched between the first end surface 711 and the second end surface 712 and at which one surface of the first electrode layer 211 is exposed.

The second partial removal portion 72 is formed from a first end surface 721 and a second end surface 722, which are an aggregate of the end surfaces of layers of the second electrode layer 221 through to the light absorbing layer 31, and an electrode exposure surface 723 which is sandwiched between the first end surface 721 and the second end surface 722 and at which one surface of the first electrode layer 211 is exposed.

The first partial removal portion 71 and the second partial removal portion 72 are formed so as to sandwich the cutting schedule line A therebetween.

In this embodiment, for example, the first partial removal portion 71 and the second partial removal portion 72 are formed so as to extend in the shorter direction TD of the elongated solar battery element 11. The first partial removal portion 71 and the second partial removal portion 72 may be formed substantially in parallel with the shorter direction TD, or may be formed obliquely to the shorter direction.

The widths W1 and W2 of the first partial removal portion 71 and the second partial removal portion 72 are not particularly limited. Since the first partial removal portion 71 and the second partial removal portion 72 are formed for partially separating the light absorbing layer 31 from the second electrode layer 221, the widths W1 and W2 are preferably as small as possible when considering the yield of the solar battery cell. When the widths W1 and W2 are excessively large, the yield of the solar battery cell is reduced, and therefore the widths W1 and W2 of the first partial removal portion 71 and the second partial removal portion 72 are preferably 3 mm or less, and more preferably 1 mm or less.

The formation interval W3 between the first partial removal portion 71 and the second partial removal portion 72 (the interval W3 between the first end surface 711 of the first partial removal portion 71 and the second end surface 722 of the second partial removal portion 72) is not particularly limited. However, when the width W3 is excessively small, the first end surface 711 or the second end surface 722 may be caused to sag in a processing direction as a cutting tool scrapes the first end surface 711 or the second end surface 722 when the cutting tool is applied between the first partial removal portion 71 and the second partial removal portion 72 in a later-described cutting step. From such a point of view, the formation interval W3 between the first partial removal portion 71 and the second partial removal portion 72 is preferably equal to or larger than the width of the cutting tool. For example, when a push-cut blade is used as a cutting tool, the formation interval W3 between the first partial removal portion 71 and the second partial removal portion 72 is preferably 1 mm or more, more preferably more than 2 mm, and especially preferably 3 mm or more.

The width W3 is excessively large, the yield of the solar battery cell is reduced, and adjacent solar battery cells may be short-circuited when obtained solar battery cells are electrically connected to form a solar battery module. From such a point of view, the formation interval W3 between the first partial removal portion 71 and the second partial removal portion 72 is preferably 20 mm or less, and more preferably 10 mm or less.

Three or more partial removal portions may be formed at the machining portion (not illustrated).

The method for partially removing layers of the second electrode layer 221 through to the light absorbing layer 31 (method for forming the partial removal portion) is the same as the method described in the above section <Case where one partial removal portion is formed>.

The method for partially removing layers of the second electrode layer 221 through to the first electrode layer 211 is also the same as the method in the above section <Case where one partial removal portion is formed>.

By carrying out the partial removal step, layers above the first electrode layer or the base material can be partially removed to separate the layers.

Since the removal is performed by mechanical machining such as machining by a knife edge-shaped cutlery and machining by a rotary blade, or machining by irradiation of laser beams, the end surfaces (first end surface and second end surface) of the layers are hard to sag in a processing direction. Therefore, occurrence of short circuit of the first electrode layer and the second electrode layer can be prevented.

When the mechanical machining or machining by irradiation of laser beams is performed, peeling of the layers can also be prevented in layers of the second electrode layer through to the light absorbing layer.

### (Step of cutting solar battery element)

The cutting step is a step of cutting a solar battery element along a cutting schedule line or the vicinity thereof in a partial removal portion forming region after the partial removal step.

By carrying out this step, individual solar battery cells can be cut out from the element.

### <Cutting when one partial removal portion is formed>

When one partial removal portion 61 is formed as shown in Figs. 4 and 5 in the partial removal step, the element 11 is cut at the partial removal portion 61.

Specifically, the element 11 is cut at the partial removal portion 61 using a cutting tool.

The cutting tool may be applied from the opening side of the partial removal portion 61 (second electrode layer side of the element 11), or may be applied from a side opposite to the opening side of the partial removal portion 61 (base material side of the element 11). Two cutting tools may be used to apply one cutting tool from the opening side of the partial removal portion 61 and apply the other cutting tool from a side opposite to the opening side of the partial removal portion 61.

For example, as shown by the two-dot chain line in Fig. 5, the cutting tool Y is applied so as to be fitted into the partial removal portion 61 formed so as to include the cutting schedule line A. At this time, it is preferred to apply the cutting tool Y to the partial removal portion 61 so as not to come into contact with the first end surface 611 and the second end surface 612 of the partial removal portion 61. This is intended to prevent the first end surface 611 or the second end surface 612 of the partial removal portion 61 from sagging in a processing direction due to contact with the cutting tool Y. By appropriately adjusting the width W of the partial removal portion 61 and the application position of the cutting tool Y, the element 11 can be cut by the cutting tool Y without causing the cutting tool Y to come into contact with the first end surface 611 and the second end surface 612 of the partial removal portion 61.

When the partial removal portion 61 is formed such that the central portion of the partial removal portion 61 is substantially coincident with the cutting schedule line A, the cutting tool Y is aligned along the cutting schedule line A.

Symbol Z shown by the two-dot chain line in Fig. 5 denotes a cutter stand that receives the cutting tool Y (the same applies in Fig. 8). In the drawing, the element 11 and the cutter stand Z are separated from each other, but actually the element 11 is placed on the cutter stand Z.

By cutting the first electrode layer 211 and the base material 41 corresponding to the partial removal portion 61 or the base material 41 corresponding to the partial removal portion 61 using the cutting tool, the solar battery cell 1 can be cut out from the element 11.

When the width of the partial removal portion 61 is large as compared to the width of the cutting tool Y, the edge of the base material of the obtained solar battery cell may be left to protrude outward slightly from the cut surface, but this does not affect the characteristics of the solar battery cell.

Examples of the cutting tool include a push-cut blade, a rotary blade and the like.

It is preferred to cut the element by pressing a push-cut blade against the partial cut portion because the element can be cut in a relatively short time.

For example, a push-cut blade having a relatively small width (blade thickness) and a length larger than the length of the element in the shorter direction is used. When such a push-cut blade is used, the element can be cut in a thickness direction by one pressing.

### <Cutting when a plurality of partial removal portions are formed>

When two partial removal portions 71 and 72 are formed as shown in Figs. 7 and 8 in the partial removal step, the element 11 is cut between the first partial removal portion 71 and the second partial removal portion 72.

In the same as described above, the cutting tool may be applied from the opening side of the partial removal portions 71 and 72 or may be applied from a side opposite to the opening side, or two cutting tools may be used to apply one cutting tool from the opening side and apply the other cutting tool from a side opposite to the opening side.

Specifically, as shown in Figs. 7 and 8, a stacked portion 11a of the second electrode layer 221, the light absorbing layer 31, the first electrode layer 211, and the base material 41 partially remains between the first partial removal portion 71 and the second partial removal portion 72. One cutting tool Y is applied to the stacked portion 11a from the opening side of the first partial removal portion 71 and the second partial removal portion 72 (cutting tool is shown by a two-dot chain line in Fig. 8).

At this time, it is preferred to apply the cutting tool Y so as not to come into contact with the first end surface 711 of the first partial removal portion 71 and the second end surface 722 of the second partial removal portion 72. This is intended to prevent the first end surface 711 of the first partial removal portion 71 and the second end surface 722 of the second partial removal portion 72 from sagging due to contact with the cutting tool Y. By appropriately adjusting the formation interval W3 of the first partial removal portion 71 and the second partial removal portion 72 and the application position of the cutting tool, the element 11 can be cut by the cutting tool Y without causing the cutting tool Y to come into contact with the first end surface 711 of the first partial removal portion 71 and the second end surface 722 of the second partial removal portion 72.

When the first partial removal portion 71 and the second partial removal portion 72 are formed such that the central position of the stacked portion 11a is substantially coincident with the cutting schedule line A, the central part of the cutting tool Y in the width direction is aligned along the cutting schedule line A.

By cutting the element 11 between the first partial removal portion 71 and the second partial removal portion 72 using the cutting tool Y, the solar battery cell 1 can be cut out from the element 11.

The cutting tool and the cutting method are the same as the cutting tool and the cutting method described in the above section <case where one partial removal portion is formed>.

The solar battery cell of the present invention is obtained from a solar battery element by passing through the above steps.

However, the method for producing a solar battery cell according to the present invention may include other steps in addition to the steps described above.

When the element is cut through the cutting step described above, flash may occur at the cut surface, but since layers of the second electrode later through to the light absorbing layer or from the second electrode layer through to the first electrode layer are partially removed in the partial removal step described above, a solar battery cell free from short circuit of the second electrode layer and the first electrode layer can be obtained.

Since cutting is completed in a short time as compared to removal processing in the partial removal step, the time required for cutting out solar battery cells from the element is equal to the time required for removal in the partial removal step. Therefore, according to the production method of the present invention, individual solar battery cells can be efficiently cut out from the solar battery element in a relatively short time while short circuit is prevented.

### [Use of solar battery cell]

The solar battery cell of the present invention can be used as a component of a solar battery module.

Fig. 9 illustrates a schematic side view of a solar battery module which has a plurality of solar battery cells and is constituted by electrically connecting the plurality of solar battery cells.

For example, a plurality of solar battery cells 1 obtained by the production method described above are arranged between protective films 91 and 92 as shown in Fig. 9 while adjacent solar battery cells 1 are electrically connected, and a sealing resin 93 is injected, whereby a solar battery module 100 can be formed.

The method for connecting adjacent solar battery cells 1 is not particularly limited.

For example, as shown in Fig. 9, a plurality of solar battery cells 1 may be electrically connected in series by sequentially superimposing, on one end 22c of the second electrode layer 22 of one solar battery cell 1, the other end 4c of the base material 4 of the adjacent solar battery cell 1. In the solar battery module 100 of Fig. 9 in which the solar battery cells 1 are tilted and superimposed on one another, the solar battery cells 1 are arranged with the cut surfaces 1a of the solar battery cells 1 made to face in a direction substantially orthogonal to a direction B along which the solar battery cells 1 are arranged side by side. Of course, the connecting method is not limited thereto, and the solar battery cells 1 may be arranged with the cut surfaces 1a of the solar battery cells 1 made to face in the direction B along which the solar battery cells 1 are arranged side by side (not illustrated).

Alternatively, as a method for connecting adjacent solar battery cells, the solar battery cells may be arranged at intervals, followed by electrically connecting adjacent solar battery cells with a conducting wire (not illustrated).

### EXAMPLES

Hereinafter, the present invention is described in detail with reference to following Examples and Comparative Example. However, the present invention is not limited to the following Examples.

### [Example 1]

### (Formation of barrier layer)

A SUS (stainless steel plate) having a width of 20 mm, a length of 100 m and a thickness of 50 µm was used as a base material. The base material was mounted in a sputtering device, and the inside of the sputtering device was evacuated. The ultimate degree of vacuum at this time was 2.0 × 10⁻⁴ Pa. Next, an Ar gas was introduced so as to achieve a pressure of 0.1 Pa using a mass flow controller (MFC), and a Cr layer (barrier layer) having a thickness of 0.3 µm was formed on one surface of the base material from a Cr target under the condition of a sputtering rate of 30 nm·min/m using a magnetron sputtering-type sputtering film formation method. The sputtering rate is a sputtering rate per unit carrying speed when sputtering is performed while the base material is carried.

### (Formation of first electrode layer)

The base material with the barrier layer was mounted in a sputtering device, and the inside of the sputtering device was evacuated. The ultimate degree of vacuum at this time was 2.0 × 10⁻⁴ Pa. Next, an Ar gas was introduced so as to achieve a pressure of 0.1 Pa using a mass flow controller (MFC), and a Mo layer (first electrode layer) having a thickness of 0.3 µm was formed on one surface of the barrier layer from a Mo target under the condition of a sputtering rate of 30 nm·min/m using a DC magnetron sputtering-type sputtering film formation method.

### (Formation of light absorbing layer)

A cell containing Ga, a cell containing In, a cell containing Cu and a cell containing Se were sequentially arranged as vapor deposition sources in a chamber of a vacuum vapor deposition device. The base material was mounted in the chamber, the inside of the chamber was evacuated to a degree of vacuum of 1.0 × 10⁻⁴ Pa, and the base material was heated to 550°C. The vapor deposition sources were heated to 1150°C for Cu, 800°C for In, 950°C for Ga and 150°C for Se to vaporize the elements at the same time, thereby forming on one surface of the first electrode layer a CIGS layer (light absorbing layer) formed of a chalcopyrite compound. The carrying speed of the base material was 0.1 m/min.

The formed light absorbing layer had a thickness of 2 µm as measured using a scanning electron microscope. The chalcopyrite compound of the light absorbing layer had a composition of Cu : In : Ga : Se = 23 : 20 : 7 : 50 [% by atomic number] as measured using energy dispersive X-ray spectroscopy.

### (Formation of buffer layer)

0.001 mol/l of cadmium acetate (Cd(CH₃COOH)₂), 0.005 mol/l of thiourea (NH₂CSNH₂), 0.01 mol/l of ammonium acetate and 0.4 mol/l of ammonia were mixed at room temperature. The elongated base material provided with the light absorbing layer was immersed in a rolled state in the mixed solution, and heated from room temperature to 80°C for 15 minutes using a water bath heated at 80°C, thereby forming a CdS layer (first buffer layer) on one surface of the light absorbing layer (CBD method). The formed CdS film had a thickness of about 70 nm as measured using a method called ellipsometry.

The base material was mounted in a sputtering device so as to form a film on one surface of the first buffer layer, and the inside of the sputtering device was evacuated. The ultimate degree of vacuum at this time was 2.0 × 10⁻⁴ Pa. Next, an Ar gas was introduced so as to achieve a pressure of 0.2 Pa using a mass flow controller (MFC), and a ZnO layer (second buffer layer) having a thickness of 100 nm was formed from a ZnO target under the condition of a sputtering rate of 10 nm·min/m using a RF magnetron sputtering-type sputtering film formation method.

### (Formation of second electrode layer)

Finally, the base material was mounted in a sputtering device (manufactured by ULVAC, Inc.) so as to form a film on one surface of the second buffer layer, and the inside of the device was evacuated. The ultimate degree of vacuum at this time was 2.0 × 10⁻⁴ Pa. Next, an Ar gas was introduced so as to achieve a pressure of 0.3 Pa using a mass flow controller (MFC), and an ITO layer (second electrode layer) having a thickness of 0.5 µm was formed from an ITO target (In₂O₃:90 [% by atomic number], SnO₂:10 [% by atomic number]) under the condition of a sputtering rate of 50 nm·min/m using a DC magnetron sputtering-type sputtering film formation method. In this way, a solar battery element of Example 1 was prepared.

### (Preparation of solar battery cell)

One partial removal portion was formed along a cutting schedule line of the prepared elongated solar battery element.

Specifically, a disc-shaped rotary blade coated with an artificial diamond abrasive grain (manufactured by DISCO Corporation, trade name: Z05-SD5000-D1A-105 54 × 2A3 × 40 × 45N-L-S3) was provided as a machining tool, and the solar battery element was machined while the rotary blade was rotated, so that partial removal portions extending like a belt in a shorter direction were formed at intervals of 300 mm in a longer direction of the element. The width of each partial removal portion was 1 mm, and layers of the ITO layer (second electrode layer) through to the CIGS layer (light absorbing layer) were machined.

Next, a push-cut blade having a blade tip angle of 30 degrees and a blade width of 2 mm was provided as a cutting tool, and the push-cut blade was pressed against the center of the partial removal portion to cut the whole solar battery element in a thickness direction, thereby obtaining a solar battery cell having a width of 20 mm and a length of 300 mm.

### [Example 2]

An elongated solar battery element was prepared in the same manner as in Example 1.

A solar battery cell was obtained by forming a partial removal portion on the element and cutting the element in the same manner as in Example 1 except that layers of the ITO layer (second electrode layer) through to the Mo layer (first electrode layer) were machined when the partial removal portion was formed.

### [Example 3]

An elongated solar battery element was prepared in the same manner as in Example 1.

Two partial removal portions were formed with a cutting schedule line of the prepared elongated solar battery element sandwiched therebetween.

Specifically, a disc-shaped rotary blade coated with an artificial diamond abrasive grain was provided as a machining tool, and the solar battery element was machined while the rotary blade was rotated, so that first partial removal portions extending like a belt in a shorter direction were formed at intervals of 300 mm in a longer direction of the element. The width of each first partial removal portion was 1 mm, and layers of the ITO layer (second electrode layer) through to the CIGS layer (light absorbing layer) were machined.

Similarly, second partial removal portions parallel to the first partial removal portions were each formed at a distance of 10 mm from the first partial removal portion to one side in the longer direction using the rotary blade. The width of each second partial removal portion was 1 mm, and layers of the ITO layer (second electrode layer) through to the CIGS layer (light absorbing layer) were machined.

Next, a push-cut blade having a blade tip angle of 30 degrees and a blade width of 2 mm was provided as a cutting tool, and the push-cut blade was pressed against a center with a width of 10 mm, which was sandwiched between the first partial removal portion and the second partial removal portion, to cut the whole solar battery element in a thickness direction, thereby obtaining a solar battery cell having a width of 20 mm and a length of 300 mm.

### [Example 4]

An elongated solar battery element was prepared in the same manner as in Example 1.

A solar battery cell was obtained by forming first and second partial removal portions on the element and cutting the element between the portions in the same manner as in Example 3 except that layers of the ITO layer (second electrode layer) through to the Mo layer (first electrode layer) were machined when the first and second partial removal portions were formed.

### [Comparative Example]

An elongated solar battery element was prepared in the same manner as in Example 1.

A push-cut blade having a blade tip angle of 30 degrees and a blade width of 2 mm was provided as a cutting tool to cut the whole solar battery element at intervals of 300 mm in a thickness direction, thereby obtaining a solar battery cell having a width of 20 mm and a length of 300 mm.

### [Evaluation of short circuit of element of solar battery]

The solar battery cells of Examples 1 to 4 and Comparative Example were evaluated on whether or not short circuit occurred and whether or not the light absorbing layer was peeled in association with power generation. The results are shown in Table 1.

Short circuit of the solar battery cell was evaluated based on the characteristics of the solar battery device.

Specifically, artificial sunlight (air mass (AM) = 1.5, 100 mW/cm²) was applied to each solar battery cell, and evaluation was performed using an IV measurement system (manufactured by Yamashita Denso Corporation).

Evaluation was performed by visual observation on whether or not the light absorbing layer was peeled in association with power generation.

These evaluations were intended for 100 solar battery cells prepared in Examples 1 to 4 and Comparative Example. In the evaluation results in Table 1, the denominator represents the number of intended cells (100), and the numerator represents the number of solar battery cells that were short-circuited and solar battery cells that caused peeling

**[Table 1]**

| | Removed layers | Number of partial removal porion | Short-circuited cell | Peeled cell |
|---|---|---|---|---|
| Example 1 | ITO/ZnO/CdS/CIGS | 1 | 0/100 | 0/100 |
| Example 2 | ITO/ZnO/CdS/CIGS/Mo | 1 | 0/100 | 0/100 |
| Example 3 | ITO/ZnO/CdS/CIGS | 2 | 0/100 | 0/100 |
| Example 4 | ITO/ZnO/CdS/CIGS/Mo | 2 | 0/100 | 0/100 |
| Comparative Example | - | None | 90/100 | 100/100 |

### [Results]

The solar battery cells of Examples 1 to 4 obtained by cutting the solar battery element by a push-cut blade after performing partial removal by machining were capable of suppressing short circuit of electrode layers or the second electrode layer and the conductive material, and did not cause peeling of the light absorbing layer.

On the other hand, the solar battery cell of Comparative Example obtained by cutting the solar battery element by a push-cut blade without performing machining was short-circuited and caused peeling of the light absorbing layer in a large number of samples.

1... Solar battery cell, 11... Solar battery element, 100... Solar battery module, 21. 211... First electrode layer, 22. 221... Second electrode layer, 3, 31... Light absorbing layer, 4. 41... Base material, 5. 51... Buffer layer, 6. 61. 71. 72... Partial removal portion

## Claims

1. A method for producing a solar battery cell in which a solar battery cell is obtained from an elongated solar battery element including an elongated flexible base material, a first electrode layer, a light absorbing layer, and a second electrode layer in this order, the method comprising the steps of:
a partial removal step of forming on the solar battery element at least one partial removal portion extending like a belt by partially removing layers of the second electrode layer through to the light absorbing layer or the second electrode layer through to the first electrode layer; and
a cutting step of cutting the solar battery element at the partial removal portion.

2. A method for producing a solar battery cell in which a solar battery cell is obtained from an elongated solar battery element including an elongated flexible base material, a first electrode layer, a light absorbing layer, and a second electrode layer in this order, the method comprising the steps of:
a partial removal step of forming on the solar battery element at least two partial removal portions extending like a belt by partially removing layers of the second electrode layer through to the light absorbing layer or the second electrode layer through to the first electrode layer; and
a cutting step of cutting the solar battery element between the two partial removal portions.

3. The method for producing a solar battery cell according to claim 1, wherein the width of the partial removal portion is equal to or larger than the width of a cutting tool.

4. The method for producing a solar battery cell according to any one of claims 1 to 3, wherein removal in the partial removal step is performed by machining processing by a knife edge-shaped cutlery or a rotary blade, or irradiation of laser beams, and
cutting in the cutting step is performed by pressing with a push-cut blade.

5. The method for producing a solar battery cell according to any one of claims 1 to 4, wherein in the partial removal step, the belt-like partial removal portion is formed in a direction substantially orthogonal to a longer direction of the elongated solar battery element.

6. A solar battery module, wherein the solar battery module comprises a plurality of solar battery cells obtained by the method according to any one of claims 1 to 5, and the plurality of solar battery cells are electrically connected to one another.
